# EUROPEAN PATENT APPLICATION

(11) **EP 1 300 881 A2**
(43) Date of publication of application: **09.04.2003**
(21) Application number: 02022450.7
(22) Date of filing: 04.10.2002
(51) Int. Cl.: H01L 21/50

(54) **Method of manufacturing semiconductor packaging**

(30) Priority: 05.10.2001 JP 2001309491
(71) Applicant: NEC Compound Semiconductor Devices, Ltd., Kawasaki-shi, Kanagawa (JP)
(72) Inventor: Kishi, Kazuhiro, Yamagata-shi, Yamagata (JP)
(74) Representative: Glawe, Delfs, Moll & Partner

(57) **Abstract**

A method of manufacturing semiconductor packaging according to the present invention includes a first step of mounting a component on a heat spreader with high melting point solder, and a second step of adhering a frame, which is formed separate from the heat spreader, upon the heat spreader so as to surround the component following completion of the first step.

## Description

### BACKGROUND OF THE INVENTION

### Field of the Invention

The present invention relates to a method of manufacturing semiconductor packaging. In particular, it relates to amethod of manufacturing semiconductor packaging that houses components such as semiconductor elements inside the frame upon a heat spreader.

### Description of the Prior Art

A high output/ high frequency semiconductor is often used for the signal amplifier in a transmitter, and for example, may be used as an amplifier for a mobile communication base station. Recently, as markets expand, due to growing price competition among mobile communication companies, demands are being made for streamlined base station structure and drastic reductions in cost. Implementation of streamlined structures and cost reduction has become an important factor for high output/ high frequency semiconductors used in the base station signal transmitter.

To achieve this objective, methods of manufacturing cost reduction through automation and simplification of the manufacturing processes for the high output/ high frequency semiconductor, or cost reduction in the parts used (i.e. ceramic packaging, internally mounted members, caps) are normally employed.

Nevertheless, there is a limit to the cost reductions that can be achieved in the high output/ high frequency semiconductor with these methods. In particular, it is not possible to cut semiconductor costs as drastically as customers are demanding because a ceramic package currently used for high output/high frequency semiconductors is configured from a ceramic lead frame and heat spreader, which have high unit costs, in order to secure exo-ergic properties in semiconductor elements.

Consequently, there is a method for reducing packaging unit costs where, for instance, the packaging is made from plastic molding.

This method has already been applied to semiconductors with mid-range output or less, and has shown some success in reducing costs.

However, for application of plastic molding packages for high output/ high frequency semiconductors, a hollow package interior is desired so as to minimize deterioration of high frequency characteristics, and unlike with those used for mid-range output semiconductors, the inside of the package cannot be filled with a molding resin.

In addition, even if the lead frame that formed the molding is first formed on the heat spreader and the interior made hollow, the following new problem develops.

Namely, since it is a high output semiconductor, the semiconductor elements require packaging using low thermal resistance solder with a high melting point of at least 300° C such as AuSn or AuSi in order to obtain exo-egeric properties for the semiconductor elements mounted inside the package. Accordingly, when fusing this low thermal resistance solder, the lead frame made from the molding resin is exposed at a temperature of at least 300° C. However, since the heat resistance temperature of the molding resin is no greater than 300° C, if it is exposed a temperature greater than 300° C, the degradation of the molding resin will occur, it will eventually carbonize, and as a result, the strength of the molding resin will decrease.

### BRIEF SUMMARY OF THE INVENTION

### Objects of the Invention

The object of the present invention is to provide a method of manufacturing semiconductor packaging that allows semiconductor elements to be mounted using solder with a high melting point while allowing a lead frame made of molding resins to be made hollow without causing any thermal effects to the lead frame.

### Summary of the Invention

An aspect of the present invention provides a method of manufacturing semiconductor packaging including a first step of mounting a component on a heat spreader with high melting point solder, and a second step of adhering a frame, which is formed separate from the heat spreader, upon the heat spreader so as to surround the component following completion of the first step.

### BRIEF DESCRIPTION OF THE DRAWINGS

The above-mentioned and other objects features and advantages of this invention will become more apparent by reference to the following detailed description of the invention taken in conjunction with the accompanying drawings, wherein:
FIG. 1 is a perspective view of a semiconductor package according to a first embodiment of the present invention;
FIG. 2 is a cross-sectional diagram cut along line A-A in FIG. 1; and
FIG. 3 is a process diagram showing the manufacturing process for the semiconductor package shown in FIG. 1.

### DETAILED DESCRIPTION OF THE INVENTION

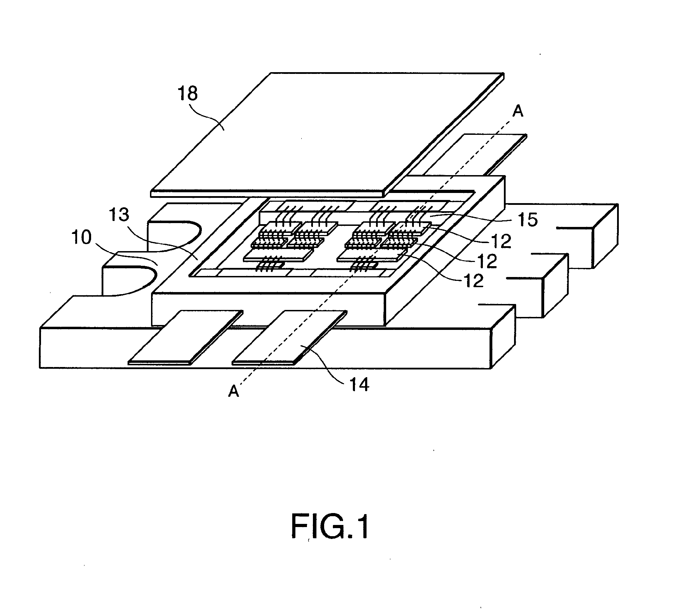

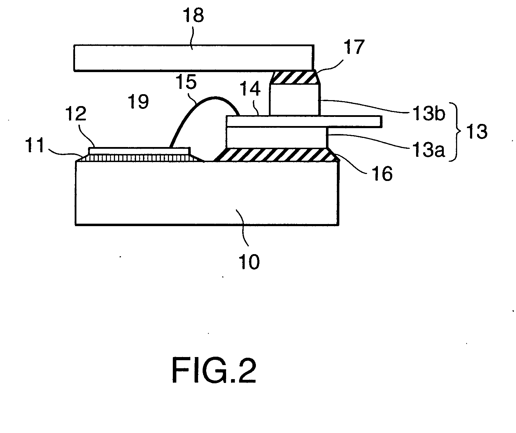

FIG. 1 is a perspective view of a high frequency/ high output semiconductor package according to a first embodiment of the present invention, and FIG. 2 is a cross- sectional diagram cut along line A-A in FIG. 1.

As shown in FIG. 1 and FIG. 2, the semiconductor packaging according this embodiment is configured from a CuW or CMC heat spreader 10; a plurality of electronic components 12 such as the semiconductor chip, which are mounted upon the heat spreader 10 using high-melting point solder 11; molding frame 13, which is adhered and affixed upon the heat spreader 10; bonding wires 15, which connect connection terminals 14 supported by the molding frame 13 with the various electronic components 12; and a cap 16, which encloses the opening of the molding frame 13 so as to seal the molding frame 13.

As shown in FIG. 2, the molding frame 13 is configured from a lower portion 13a that has an outer shape that is substantially rectangular and a hollow internal structure, and an upper portion 13b, which integrally formed with the lower portion 13a on top of the lower portion 13a. Like the lower portion 13a, the upper portion 13b also has an outer shape that is substantially rectangular and has a hollow internal structure. The lower portion 13a and upper portion 13b have substantially equal external diameters, whereas the upper portion 13b has a larger internal diameter than the lower portion 13a. As a result, the inside of the molding frame 13 has an overall hollow structure.

The molding frame 13 is formed separate from the heat spreader 10, and as described later, is adhered upon the heat spreader 10 with a low-elastic, liquid epoxy resin 16 so as to house the electronic components 12 inside the hollowinterior, following mounting of the electronic components 12 upon the heat spreader 10.

Openings are formed between the lower portion 13a and upper portion 13b of the molding frame 13 (not shown in the figures), and connection terminals 14 are supported with the molding frame 13 through the insertion of the connection terminals 14 in these openings.

As shown in FIG. 2, the ends of the connection terminals 14 that are located inside the molding frame 13 are electrically connected with the electronic components 12 mounted upon the heat spreader 10, via the bonding wires 15. Signal transmission and reception between the electronic components 12 and external circuitry (not shown in the figures) is carried out via the connection terminals 14.

It should be noted that the electronic components 12 may include components such as an alumina board or a capacitor in addition to the semiconductor elements.

A substantially rectangular molding cap 18 is securely adhered onto the molding frame 13 via a sealant 17 made of a liquid epoxy resin. The molding cap 18 has an external diameter that is larger than the internal diameter of the upper portion 13b of the molding frame 13. Therefore, the openings demarcated by the upper portion 13b of the molding frame 13 are completely covered by the molding cap 18, and as a result, a hollow structure 19 is demarcated through the heat spreader 10, molding frame 13, and molding cap 18.

The high-melting point solder 11 affixing the electronic components 12 upon the heat spreader 10 is configured from AuSn. An arbitrary solder may be used as the high-melting point solder 11 as long as it has a melting point of at least 300° C. In place of the AuSn solder, for instance, an AuSi solder may be used.

The advantages of the semiconductor packaging according to this embodiment are described forthwith.

As described above, the packaging of a high frequency/high output semiconductor must be hollow in order to prevent deterioration of the high frequency characteristics.

In addition, as the semiconductor elements are high output, a heat spreader configured from copper or CuW is required for the mounting portion for the semiconductor elements, and moreover, a solder having low thermal resistance is required when mounting the semiconductor elements upon the heat spreader. An AuSn solder or AuSi solder or the like, which has a melting point of at least 300° C may be used as the low thermal resistance solder.

In addition, in order to be a viable low cost packaging solution, the packaging must be made through molding. Nevertheless, since a high output semiconductor has many mounted components, the molding package is exposed to high temperatures for a span of several minutes as component mounting is performed while fusing solder having a high melting point. However, should the molding be left at a high temperature, degradation may set in and strength may deteriorate.

The semiconductor packaging according to this embodiment solves all of the above-mentioned concerns.

More specifically, firstly, the molding frame 13 is formed including a hollow structure 19. This allows the deterioration of high frequency characteristics to be prevented with this semiconductor packaging.

Secondly, since the molding frame 13 and the heat spreader' 10 are formed as separate components, it is possible to affix the molding frame 13 onto the heat spreader 10 after the electronic components 12 have been mounted upon the heat spreader 10. Therefore, if the molding frame 13 is mounted upon the heat spreader 10 after the electronic components 12 are mounted onto the heat spreader 10 with the high-melting point solder 11, the high-melting point solder 11 may be used without exposing the molding frame 13 to the high temperature for fusing the high-melting point solder 11, and accordingly, deterioration in the strength of the molding frame 13 may be prevented.

Thirdly, compared with conventionally used ceramic packaging, it is possible to drastically reduce packaging unit costs with the semiconductor packaging according to this embodiment. More specifically, the manufacturing unit cost of the semiconductor packaging according to this embodiment is approximately one-eighth the manufacturing unit cost of conventional ceramic packaging.

It should be noted that the molding frame 13 is not always required to be made from molding resin. For example, a frame configured from ceramic may be used in place of the molding frame 13 and packaging unit cost reduction is also possible with a ceramic frame.

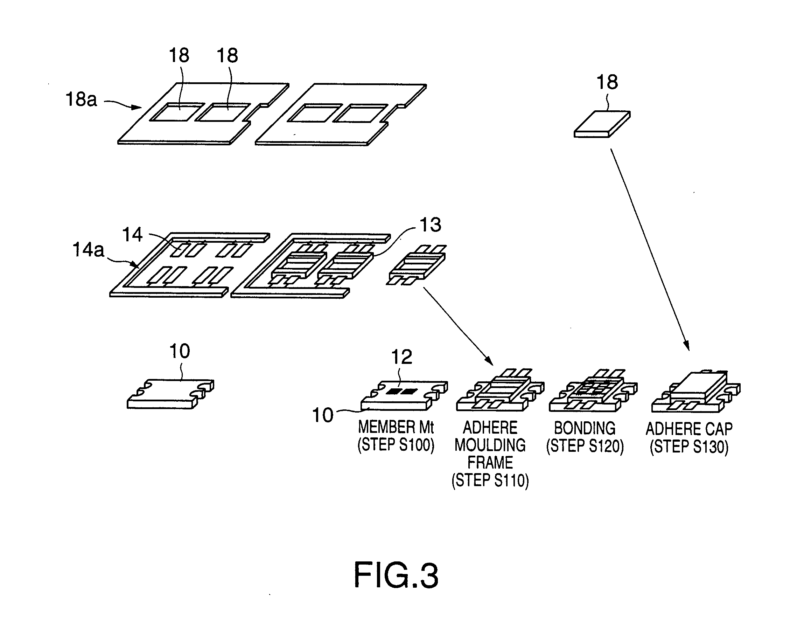

FIG. 3 is a diagram showing the manufacturing process for the semiconductor packaging according to this embodiment. An example of a manufacturing process for the semiconductor packaging according to this embodiment is described forthwith while referencing FIG. 3.

To begin with, the heat spreader 10, connection terminals 14, and molding cap 18 are formed beforehand. The connection terminals 14 and molding cap 18 are provided as lead frames 14a and 18a, which simultaneously form a plurality of connection terminals 14 and molding caps 18, respectively. The lead frames 14a and 18a are formed from molding resin.

To begin with, electronic components that should be mounted in the package are mounted upon the heat spreader 10 with a high- melting point solder 11 (step S100).

A molding frame 13 for the connection terminals 14 that configure the lead frame 14a is formed through molding. Thereafter, the molding frame 13 inserted with the connection terminals 14 is diced into individual pieces.

Continuing, a diced piece of the molding frame 13 is adhered onto the heat spreader 10 with epoxy resin 16 so as to house the electronic components in the interior thereof (step S110). Next, the electronic components 12 and the connection terminals 14 are connected with gold bonding wires 15 (step S120).

The molding cap 18 is then adhered to the molding frame 13 with sealant 17 following dicing of the molding caps 18 into individual pieces from the lead frame 18a.

As described in the above, the following results may be obtained from the semiconductor packaging and method of manufacturing the same according to the present invention.

Firstly, the interior of the semiconductor packaging may be formed with a hollow structure. Through this, deterioration of the high frequency characteristics of this semiconductor packaging may be prevented.

Secondly, since the frame and the heat spreader are formed as separate components, it is possible to affix the frame onto the heat spreader after the electronic components have been mounted upon the heat spreader. Therefore, if the frame is mounted onto the heat spreader after the electronic components have been mounted upon the heat spreader with high-melting point solder, then the high-melting point solder may be used without imparting thermal effects onto the frame.

Thirdly, as described above, if the frame is mounted onto the heat spreader after the electronic components have been mounted upon the heat spreader with high- melting point solder, then the frame is not exposed to the high temperatures required to fuse the high- melting point solder. Accordingly, deterioration in frame strength may be prevented.

Fourthly, compared with conventionally used ceramic packaging, packaging unit costs with the semiconductor packaging according to this embodiment may be drastically reduced. More specifically, the manufacturing unit cost of the semiconductor packaging according to the present invention is approximately one-eighth the manufacturing unit cost of conventional ceramic packaging.

Although the invention has been described with reference to specific embodiments, this description is not meant to be construed in a limiting sense. Various modifications of the disclosed embodiments will become apparent to persons skilled in the art upon reference to the description of the invention. It is therefore contemplated that the appended claims will cover any modifications or embodiments as fall within the true scope of the invention.

## Claims

1. A method of manufacturing semiconductor packaging, comprising:
a first step of mounting a component on a heat spreader with high melting point solder; and
second step of adhering a frame, which is formed separate from said heat spreader, upon said heat spreader so as to surround said component following completion of said first step.

2. A method of manufacturing semiconductor packaging, comprising:
a first step of mounting a component on a heat spreader with high melting point solder;
a second step of adhering a frame, which is formed separate from said heat spreader, upon said heat spreader so as to surround said component following completion of said first step;
a third step of connecting connection terminal supported with said frame to said component through a bonding wire; and
a fourth step of sealing said frame with a cap.
